# EUROPÄISCHE PATENTSCHRIFT

(11) **EP 2 966 420 B1**
(45) Veröffentlichungstag und Bekanntmachung des Hinweises auf die Patenterteilung: **18.07.2018**
(21) Anmeldenummer: 15000398.6
(22) Anmeldetag: 11.02.2015
(51) Int. Cl.: G01F 1/716, G01F 1/74, H03H 7/38, G01R 33/30

(54) **Verfahren zum Betreiben eines kernmagnetischen Durchflussmessgerätes**
Method for operating a nuclear magnetic flow meter
Procédé de fonctionnement d'un appareil de mesure de débit à noyau magnétique

(30) Priorität: 10.07.2014 DE 102014010237; 30.10.2014 DE 102014015943
(43) Veröffentlichungstag der Anmeldung: 13.01.2016
(60) Teilanmeldung: 18177334.2
(73) Patentinhaber: Krohne AG, 4019 Basel (CH)
(72) Erfinder: Hogendoorn, Cornelis Johannes, 4211 BG Sijk (NL); Tromp, Rutger Reinout, 3311 EM Dordrecht (NL); Bousché, Olaf Jean Paul, 3319 PH Dordrecht (NL); Zoeteweij, Marco Leendert, 3344 EP Hendrik-Ido-Ambach (NL); Ceferino Cerioni, Lucas Matias, 3311 GN Dordrecht (NL)
(74) Vertreter: Gesthuysen Patent- und Rechtsanwälte

(56) Entgegenhaltungen:
- EP-A2- 0 510 774
- WO-A2-2004/099817
- US-A- 4 769 602
- US-A- 4 855 695
- US-A1- 2006 020 403

## Beschreibung

Die Erfindung betrifft ein Verfahren zum Betreiben eines kernmagnetischen Durchflussmessgerätes zur Bestimmung des Durchflusses eines durch ein Messrohr mit Schwallströmung strömenden Mediums mit einer Messeinrichtung, wobei die Messeinrichtung einen RF-Kreis mit einer externen Elektronik und mit mindestens einer zum Erzeugen von das Medium anregenden Anregungssignalen und/oder zur Detektion von vom Medium ausgesandten Messsignalen ausgestalteten RF-Spule umfasst.

Kernmagnetische Durchflussmessgeräte sind zur Bestimmung des Durchflusses eines durch ein Messrohr strömenden Mediums ausgebildet. Das Medium kann eine Phase oder mehrere Phasen beinhalten. Bei einem einphasigen Medium erfolgt die Bestimmung des Durchflusses durch die Bestimmung der Strömungsgeschwindigkeit des Mediums. Die Bestimmung des Durchflusses eines mehrphasigen Mediums umfasst neben der Bestimmung der Strömungsgeschwindigkeit ebenfalls die Bestimmung der Anteile der einzelnen Phasen an dem Medium. Aus der US2006/0020403 A1 ist ein kernmagnetisches Messgerät bekannt, welches in Echtzeit unmittelbar die Anteile und Durchflüsse von Phasen eines mehrphasigen Mediums bestimmt.

Grundvoraussetzung für die Anwendbarkeit kernmagnetischer Messmethoden ist, dass das Medium oder jede Phase des Mediums Atomkerne mit magnetischen Momenten aufweist. Zur Unterscheidung der einzelnen Phasen ist es zudem nötig, dass die Phasen unterscheidbare Relaxationszeiten besitzen.

Das aus Ölquellen geförderte mehrphasige Medium besteht im Wesentlichen aus den beiden flüssigen Phasen Rohöl und Salzwasser und der gasförmigen Phase Erdgas, wobei alle drei Phasen Wasserstoffkerne enthalten, die ein magnetisches Moment tragen.

Das durch das Messrohr des Durchflussmessgerätes strömende Medium kann verschiedene Strömungscharakteristiken aufweisen. Das bedeutet, dass die einzelnen Phasen des Mediums über ein Volumenelement gesehen verschieden verteilt sein können. Eine häufig auftretende Strömung bei aus Ölquellen geförderten Medien ist die Schwallströmung. Die Schwallströmung weist eine sehr komplexe Charakteristik auf und ist im Wesentlichen durch eine ständige Unterbrechung einer gleichmäßigen Strömung gekennzeichnet. Eine Schwallströmung kann in zwei Bereiche aufgeteilt werden, die abwechselnd auftreten. Der erste Bereich ist durch einen Schwall an flüssigem Medium gekennzeichnet, wobei das flüssige Medium den gesamten Messrohrquerschnitt ausfüllt. In dem flüssigen Medium sind kleine Gasblasen unregelmäßig verstreut. Dieser Bereich wird als Schwallbereich bezeichnet. Der zweite Bereich besteht aus einer großen Gasblase, die einen dominierenden Teil des Messrohrquerschnitts einnimmt, und einem Flüssigkeitsfilm, der den verbleibenden Bereich des Messrohrquerschnitts ausfüllt. Dieser Bereich wird als Filmbereich bezeichnet. Die Ausdehnungen der beiden abwechselnden Bereiche sind beliebig und unregelmäßig.

Kernmagnetische Durchflussmessungen sind dadurch charakterisiert, dass ein das Medium anregender Anregungspuls in einer externen Elektronik erzeugt wird, der Anregungspuls durch eine RF-Spule in das Medium eingespeist wird, und mit einer RF-Spule die Antwort des angeregten Mediums detektiert wird und zur Verarbeitung ebenfalls an eine externe Elektronik übertragen wird. Ein kernmagnetisches Durchflussmessgerät umfasst also zumindest eine externe Elektronik und eine vom Medium durchströmte RF-Spule, die zusammen einen RF-Schwingkreis bilden. Das die RF-Spule durchströmende Medium muss hierbei als eine zusätzliche Last in dem RF-Schwingkreis betrachtet werden.

Durch das sogenannte "tuning" wird die Frequenz des RF-Kreises so eingestellt, dass Resonanz erreicht wird, also das maximal mögliche Signal.

Um eine maximale Leistungsübertragung zwischen externer Elektronik und RF-Spule zu garantieren, muss die Impedanz der Spule der der externen Elektronik angepasst werden. Dieser Vorgang wird als "Anpassen" oder "matching" bezeichnet. Ein falsches bzw. ungenaues "matching", führt dazu, dass die Leistung nicht vollständig übertragen, sondern teilweise reflektiert wird. Wird Leistung reflektiert, wird nicht genug Leistung in die Spule gegeben. Das führt dazu, dass das von der RF-Spule erzeugte Magnetfeld B₁ nicht die vorgesehene Stärke aufweist und demnach die Magnetisierung des Mediums um einen kleineren Wert als den vorgesehenen Wert ausgelenkt wird.
Ein unzureichendes "matching" führt zudem auch bei der Detektion der von der Probe ausgesendeten Messsignale zu Schwierigkeiten. Das von der Probe ausgesendete Messsignal, das meist sehr klein ist, "wirkt" bei falschem "matching" noch schwächer, was auch zu einem sehr schlechten Signal-RauschVerhältnis führt.
Vor einer jeden kernmagnetischen Durchflussmessung müssen, um optimale Messbedingungen zu garantieren, das "tuning" und "matching" eingestellt werden.
Wie bereits ausgeführt, sind die Einstellungen für das "matching" von der Impedanz der RF-Spule abhängig. Bei dem Wert für die Impedanz der RF-Spule wird die zusätzliche, durch das Medium auftretende Last berücksichtigt. Die Last des Mediums hängt von der Charakteristik des Mediums ab. Strömt ein eine Schwallströmung aufweisendes Medium durch das Messrohr, ist die zusätzliche Last in dem RF-Schwingkreis eine andere, wenn sich gerade ein Schwallbereich in der RF-Spule befindet, als wenn sich ein Filmbereich in der Spule befindet.
Demnach müssten je nach Bereich die Einstellungen für das Matching korrigiert werden, was praktisch nicht möglich oder sehr aufwendig ist.
Aus der Praxis ist bekannt, aufwendige Datenanalysealgorithmen bei der Datenauswertung zu verwenden, die zwischen den beiden Bereichen unterscheiden können. Diese Algorithmen sind jedoch sehr aufwendig, wodurch die Datenauswertung sehr zeitaufwendig und zudem auch fehlerbehaftet wird.
Aufgabe der Erfindung ist die Angabe eines Verfahrens zum Betreiben eines kernmagnetischen Durchflussmessgerätes, bei dem die aus dem Stand der Technik bekannten Nachteile minimiert und die Datenhandhabung vereinfacht wird.

Die zuvor hergeleitete und aufgezeigte Aufgabe ist durch ein Verfahren zum Betreiben eines kernmagnetischen Durchflussmessgerätes gemäß dem unabhängigen Patentanspruch 1 gelöst. Das erfindungsgemäße Verfahren eignet sich in besonderer Weise zum Vermessen von Medien mit hohem Salzgehalt, insbesondere von Medien mit einem großen Anteil an Salzwasser, das einen hohen Salzgehalt aufweist. Insbesondere bei sehr salzhaltigen Medien unterscheiden sich die auftretenden Lasten bei hohem und niedrigem Flüssigkeits-Volumen-Verhältnis im RF-Kreis in einem großen Maße, so dass verschiedene Messmodi zur Vermessung der verschiedenen Bereiche unabdingbar sind, wenn auf eine aufwendige Datenanalyse verzichtet werden soll.
Um ein Durchflussmessgerät zu kalibrieren, also um die "tuning"-Parameter und die "matching"-Parameter für die jeweiligen Bereiche, also den Schwallbereich und den Filmbereich, zu bestimmen, kann während der Kalibration eine die Variationen der "tuning"-Parameter und der "matching"-Parameter beschreibende Kurve aufgenommen werden. Anhand der Kurve kann dann ein Wert für die jeweiligen Parameter sowohl im Schwallbereich als auch im Filmbereich bestimmt werden.
Ein niedriger Wert der reflektierten Leistung bedeutet, dass die Parameter für das "matching" gut sind, die Leistung also von der externen Elektronik auf die RF-Spule (fast) vollständig übertragen wird, wohingegen bei einem schlechten "matching" die reflektierte Leistung hoch ist. Sind die Parameter für einen bestimmten Bereich eingestellt, kann anhand der reflektierten Leistung bestimmt werden, ob sich gerade der Bereich, auf den die Parameter abgestimmt sind, oder der andere Bereich in der RF-Spule befindet. Hierbei muss die reflektierte Leistung in einer guten zeitlichen Auflösung gemessen werden, also hinreichend kleine Zeitintervalle zwischen den einzelnen Messungen gewählt werden. Durch die Erhöhung der zeitlichen Auflösung der Messungen erhöht sich die Genauigkeit der Detektion der Schwallbereiche und der Filmbereiche in dem Medium. Die RF-Leistung, bei der die Reflexionsmessungen durchgeführt werden, sollte ausreichend klein gewählt werden, um zu vermeiden, dass das sich in der RF-Spule befindliche Medium gestört wird. Zu beachten ist jedoch auch, dass relativ lange RF-Pulse notwendig sind, um ein stabiles Auslesen der reflektierten Leistung zu ermöglichen.

Durch das erfindungsgemäße Verfahren wird garantiert, dass die Messungen mit auf die jeweilige Last des Mediums - abhängig von dem sich in der RF-Spule befindlichen Bereich des Mediums - abgestimmten Parametern durchgeführt werden, also dass ein Schwallbereich mit Schwallbereich-Einstel-lungen und ein Filmbereich mit Filmbereich-Einstellungen gemessen wird. Gegenüber dem Stand der Technik bietet das erfindungsgemäße Verfahren den Vorteil, dass zur Datenanalyse auf einen aufwendigen Dateninterpretationsalgorithmus, der zwischen den beiden Durchflusssituationen unterscheiden kann, verzichtet werden kann.

Eine besondere Ausführungsform des erfindungsgemäßen Verfahrens ist dadurch gekennzeichnet, dass die Messung, die durch den Sprung von einem hohen zu einem niedrigen Wert der reflektierten Leistung gestartet wird, eine Messung zur Optimierung der "tuning"-Parameter und der "matching"-Parameter ist, dass startend von den Anfangsparametern weitere Punkte im "tuning"-und-"matching"-Parameterraum vermessen werden, wobei die Anzahl der Messpunkte auf der bekannten minimalen Schwallverweilzeit und der Zeit, die ein einzelner "tuning"-und-"matching"-Messpunkt benötigt, basiert, dass nach der Aufnahme der Messpunkte die Anfangsparameter wieder eingestellt werden und überprüft wird, ob die reflektierte Leistung noch einen niedrigen Wert hat und dass ein Teil der aufgenommenen Messpunkte verworfen wird oder alle aufgenommenen Messpunkte verworfen werden, wenn die reflektierte Leistung bei der Überprüfung einen hohen Wert hat.

Durch diese Ausgestaltung des erfindungsgemäßen Verfahrens können die "tuning"-Einstellungen und die "matching"-Einstellungen sowohl für den Schwallbereich als auch für den Filmbereich optimiert werden.

Eine weitere bevorzugte Ausgestaltung des erfindungsgemäßen Verfahrens ist dadurch gekennzeichnet, dass die Messung, deren Start durch den Sprung der gemessenen Leistung von einem hohen zu einem niedrigen Wert ausgelöst wird, eine kernmagnetische Messung ist.

Das erfindungsgemäße Verfahren bietet die Möglichkeit, die Daten der reflektierten Leistung zu nutzen, um einzelne Datenpunkte bzw. Messpunkte aus einer einzelnen kernmagnetischen Messung zu akzeptieren oder zu verwerfen. Insbesondere können die Daten der kernmagnetischen Messung verworfen werden, die zum Zeitpunkt eines Sprungs in der reflektierten Leistung aufgenommen wurden. Eine Messung während eines Sprungs tritt vor allem dann auf, wenn eine kernmagnetische Messung über einen längeren Zeitraum erfolgt, als die Aufenthaltsdauer des entsprechenden Bereichs in der RF-Spule ist. Ist die Messdauer größer als die Aufenthaltsdauer, werden die Messungen am "Ende" der Messung mit "falschen" Einstellungen durchgeführt. Insbesondere ist dann auch vorgesehen, die Datenpunkte bzw. Messpunkte mit den "falschen" Einstellungen zu erkennen und zu verwerfen. Hierdurch sinken erneut die Anforderungen an die bei der Datenauswertung verwendeten Dateninterpretationsalgorithmen und der bei der Datenauswertung betriebene Aufwand wird deutlich reduziert.

Eine besondere Ausgestaltung des erfindungsgemäßen Verfahrens ist dadurch gekennzeichnet, dass die Parameter für den Schwallbereich des Mediums eingestellt werden. Die kernmagnetische Messung ist erfindungsgemäß durch eine CPMG-Sequenz realisiert, wobei bei der kernmagnetischen Messung die Methode der Vormagnetisierungskontrastmessung genutzt wird. Vorzugsweise ist vorgesehen, dass mit den durch die kernmagnetische Messung gewonnenen Daten die Strömungsgeschwindigkeit des Mediums und mit Hilfe der Signal-Amplituden-Daten das Wasser-Flüssigkeits-Verhältnis bestimmt werden. Das erfindungsgemäße Verfahren ist jedoch nicht auf die Verwendung einer CPMG-Sequenz beschränkt, vielmehr ist jede Pulssequenz, die zur Messung kernmagnetischer Eigenschaften verwendet wird, denkbar.

Auch kann es sich empfehlen, die Parameter für den Schwallbereich einzustellen und die kernmagnetische Messung durch Tomographie zu realisieren. Bei der Tomographie kann insbesondere eine Schichtung in z-Richtung vorgesehen werden. Zur Definition der Richtungen wird ein kartesisches Koordinatensystem zugrunde gelegt, wobei die x-Achse entlang der Strömungsrichtung liegt und die x-Achse mit der y-Achse eine waagerechte Ebene aufspannen. Die z-Achse steht demnach senkrecht auf der waagerechten Ebene. Mit den gemessenen Signalamplituden wird der Gasanteil, also der Gas-Volumen-Anteil im Schwallbereich bestimmt. Ebenfalls kann die Strömungsgeschwindigkeitsverteilung in dem Schwallbereich bestimmt werden.

Da der Gas-Volumen-Anteil auf Grundlage der Signalamplituden bestimmt wird, ist es unabdingbar, dass die richtigen Parameter eingestellt sind, also die Parameter für den entsprechenden Bereich des Mediums. Falsche Parameter führen zu nicht eindeutigen Signalamplituden, wodurch die Messungen nicht brauchbar sind.

Zwar ist eine Bestimmung der Signalamplituden und damit des Gas-Volumen-Anteils bei Messungen mit nicht auf den Bereich abgestimmten Parametern nicht möglich, erfindungsgemäß ist jedoch bei einer besonderen Ausgestaltung des Verfahrens vorgesehen, dass eine kernmagnetische Messung mit Schwallbereich-Einstellung in dem Filmbereich durchgeführt wird. Aus den gemessenen Werten kann dann die Strömungsgeschwindigkeit des Mediums im Filmbereich bestimmt werden. Die Bestimmung der Durchflussraten erfolgt mit den aus den Messungen bestimmten Werten für die Strömungsgeschwindigkeit und mit vorher bestimmten Werten für das Wasser-Flüssigkeits-Verhältnis.

Bisher beschrieben sind besondere Ausgestaltungen des erfindungsgemäßen Verfahrens, bei dem die "tuning"-Parameter und die "matching"-Parameter für einen Schwallbereich abgestimmt wurden. Erfindungsgemäß sind auch Ausführungsformen möglich, die auf der Grundlage von auf einen Filmbereich abgestimmten "tuning"-Parametern und-"matching"-Parametern basieren.

Eine weitere Ausgestaltung des erfindungsgemäßen Verfahrens sieht vor, dass die "matching"-Parameter für den Filmbereich eingestellt werden und die kernmagnetische Messung mit einer CPMG-Sequenz realisiert wird. Da nach dem erfindungsgemäßen Verfahren die kernmagnetische Messung nach dem Sprung der Messwerte für die Leistung von einem hohen zu einem niedrigen Wert erfolgt, und - wie bereits ausgeführt - ein niedriger Wert ein gutes matching bedeutet, kann mit dieser Ausführungsform des erfindungsgemäßen Verfahrens der Filmbereich des Mediums charakterisiert werden. Vorzugsweise wird die Methode der Vormagnetisierungskontrastmessung genutzt und mit den Messdaten die Strömungsgeschwindigkeit des Mediums und mit Hilfe der Signal-Amplituden-Daten das Wasser-Flüssigkeits-Verhältnis im Filmbereich bestimmt.

Das erfindungsgemäße Verfahren ist jedoch nicht auf die Verwendung einer CPMG-Sequenz beschränkt, vielmehr ist jede zur Bestimmung kernmagnetischer Eigenschaften denkbare Pulssequenz anwendbar.

Eine weitere Ausgestaltung des erfindungsgemäßen Verfahrens ist dadurch gekennzeichnet, dass mit den "matching"-Parametern für den Filmbereich die kernmagnetische Messung mit Tomographie mit Schichtung in z-Richtung ausgeführt wird. Mit den gemessenen Signalamplituden wird der Gasanteil (Gas-Volumen-Anteil) in dem Filmbereich bestimmt. Ebenfalls ist vorgesehen, dass mit den Messdaten das Flüssigkeitslevel im Messrohr bestimmt wird.

Wie bereits ausgeführt, ist zur eindeutigen Bestimmung der Signalamplituden, und damit zur Bestimmung des Gas-Volumen-Anteils in einem bestimmten Bereich des Mediums, unabdingbar, dass die "matching"-Parameter auf den entsprechenden Bereich abgestimmt sind.

Eine wiederum besondere Ausgestaltung des Verfahrens ist dadurch gekennzeichnet, dass eine kernmagnetische Messung mit Filmbereich-Parametern in dem Schwallbereich durchgeführt wird. Aus den gemessenen Werten kann dann die Strömungsgeschwindigkeit des Mediums im Schwallbereich bestimmt werden. Die Bestimmung der Durchflussraten erfolgt mit den aus den Messungen bestimmten Werten für die Strömungsgeschwindigkeit und mit vorher bestimmten Werten für das Wasser-Flüssigkeits-Verhältnis.

Eine weitere bevorzugte Ausgestaltung sieht vor, die kernmagnetische Messung durch Tomographie mit Schichtung in z-Richtung realisiert wird und dass die kernmagnetische Messung über einen Zeitraum erfolgt, der mindestens einen Schwallbereich und einen Filmbereich erfasst. Hierbei können die "matching"-Parameter den Parametern des Schwallbereichs entsprechen, ebenfalls kann aber auch vorgesehen sein, dass die Parameter den Parametern des Filmbereichs entsprechen. Demnach gibt es in jedem Fall Bereiche hoher und niedriger reflektierter Leistung. Vorzugsweise ist nun vorgesehen, dass mit den aus der Tomographie gewonnenen Daten die Strömungsgeschwindigkeiten für jeden Zeitpunkt der Messung bestimmt werden und dass anhand der Daten der reflektierten Leistung die Strömungsgeschwindigkeiten einem Bereich zugeordnet werden können.

Bisher ist davon ausgegangen worden, dass das Medium einen hohen Salzgehalt aufweist, insbesondere das Salzwasser einen hohen Salzgehalt aufweist und/oder der Salzwasseranteil im Medium hoch ist. Jedoch ist ebenfalls denkbar, dass der Salzwasseranteil am Medium gering ist oder dass der Salzgehalt in dem Salzwasser gering ist oder gegen null geht.

Wie ausgeführt, ist die durch das strömende Medium bedingte zusätzliche Last in dem RF-Schwingkreis abhängig zum einen von dem sich in der RF-Spule befindlichen Bereich und zum anderen von der Salinität des Mediums. Demnach ist auch der Betrag der reflektierten Leistung abhängig von der Salinität des Mediums. Weist das Medium einen geringen oder keinen Salzgehalt auf, ist die Last in dem RF-Kreis näherungsweise identisch für den Schwallbereich und den Filmbereich, so dass die "tuning"-Parameter und die "matching"-Parameter für beide Bereiche gleich sind. Eine Unterscheidung der Bereiche auf Grundlage der reflektierten Leistung, wie oben beschrieben, ist demnach nicht möglich.

Statt auf Grundlage der reflektierten Leistung kann auf Grundlage der Signal-amplituden zwischen dem Schwallbereich und dem Filmbereich bei einem Medium mit Schwallströmung unterschieden werden. Insoweit ist vorgesehen, dass die "tuning"-Parameter und "matching"-Parameter für einen Schwallbereich oder für einen Filmbereich eingestellt werden, dass eine kernmagnetische Messung durchgeführt wird, dass anhand der Signal-Amplituden bestimmt wird, ob sich ein Schwallbereich oder ein Filmbereich in der RF-Spule befindet und dass mit den Signal-Amplituden das Wasser-Flüssigkeits-Verhältnis und/oder der Gas-Volumen-Anteil im Schwallbereich und im Filmbereich bestimmt werden.

Für die kernmagnetische Messung kann eine CPMG-Sequenz oder eine andere zur Vermessung kernmagnetischer Größen übliche Pulssequenz verwendet werden. Ebenfalls ist es denkbar, dass die kernmagnetische Messung durch Tomographie mit Schichtung in z-Richtung realisiert wird.

In der Kernspintomographie sind verschiedene Ordnungsschemata bekannt, nach denen die Daten - insbesondere im Fourierraum - erfasst werden können.

Insbesondere bei der Anwendung der Kernspintomographie im Bereich der Durchflussmessung von strömenden Medien, die keine gleichmäßige, insbesondere keine stationäre Strömungscharakteristik aufweisen, ergeben sich besondere Anforderungen. So eignen sich einige Pulssequenzen besonders für eine hohe zeitliche Auflösung, jedoch ist hierfür eine sehr hohe Homogenität des extern angelegten Magnetfeldes unabdingbar. Pulssequenzen, die unempfindlicher gegenüber Feldinhomogenitäten sind, erzielen keine derart hohe zeitliche Auflösung.

Vorzugsweise wird zur Datenerfassung das Ordnungsschema nach dem Goldenen Schnitt angewendet.
Diese Methode ist ursprünglich aus dem Bereich der medizinischen Bildgebung bekannt, insbesondere wird sie bei Untersuchungen des Herzens oder der Lunge angewendet.

Das Ordnungsschema basierend auf dem Goldenen Schnitt gibt ein Schema an, nach dem Datenprofile im reziproken Raum aufgenommen werden. Es garantiert eine nahezu gleichmäßige Verteilung der Datenprofile für eine beliebige Anzahl an Datenprofilen. Das Schema sieht vor, Datenprofile in einer azimuthalen Schrittweite von 111,25° aufzunehmen, dem Goldenen Schnitt von 180°. Dadurch sind die radialen Linien mir der Zeit sehr gleichmäßig über den Raum verteilt. Dadurch wird garantiert, dass unabhängig von der Anzahl der für die Bildrekonstruktion genutzten Profile - insbesondere aber wenn die Anzahl der für die Bildrekonstruktion genutzten Profile einer Fibonacci-Zahl entspricht - die Profile gleichmäßig verteilt sind. Dadurch ergeben sich einige Vorteile, die insbesondere bei der Durchflussmessung eines eine Schwallströmungscharakteristik aufweisenden Mediums von Relevanz sind. Dadurch ist die Anzahl der für die Bildrekonstruktion genutzten Profile beliebig wählbar. Ist eine schnelle zeitliche Auflösung erforderlich, können wenige Profile gewählt werden, bei einer hohen räumlichen Auflösung hingegen kann die Datenrekonstruktion anhand einer Mehrzahl von Profilen erfolgen. Dieses Verfahren bietet den großen Vorteil gegenüber bisher verwendeten Verfahren in der Durchflussmesstechnik, dass die Bildrekonstruktion spontan variabel an die herrschenden Bedingungen angepasst werden kann und nicht vor der Messung bereits konkretisiert werden muss. So kann die Länge des Messfensters beliebig gewählt werden. Durch das Ordnungsschema nach dem Goldenen Schnitt ist zu jedem Zeitpunkt eine gleichmäßige Verteilung der Daten im Fourierraum gewährleistet. Dadurch ist es nicht mehr nötig, die für eine Messung benötigte zeitliche Auflösung oder Bilderneuerungsrate im Vorhinein festzulegen. Vielmehr kann die Anzahl der an der Datenrekonstruktion beteiligten Profile im Nachhinein angepasst werden, um situationsangepasst immer wieder erneut einen Kompromiss aus Bildqualität und zeitlicher Auflösung schließen zu können. Beispielsweise kann die Anzahl der Profile der Länge der Schwallbereiche und der Filmbereiche angepasst werden.
Da jedes Profil jeweils durch den Ursprung des reziproken Raumes führt, wird in jedem Profil die absolute Signalamplitude erfasst. Mit der Signalamplitude kann erkannt werden, ob es sich um einen Schwallbereich oder einen Filmbereich handelt.

Ebenfalls denkbar ist, die Position der Datenerfassungsfenster beliebig zu halten. Aufeinanderfolgende Profile werden grob über den gesamten reziproken Raum verteilt. Dadurch wird eine nahezu gleichförmige Profilverteilung über den gesamten reziproken Raum garantiert, unabhängig davon, wann die Datenaufnahme begonnen hat. Die Daten können dann den spezifischen Intervallen angepasst werden.

Es kann auch vorgesehen sein, mehrere Datenerfassungsfenster miteinander zu verschmelzen. Die Flexibilität in der Datenaufnahme erlaubt es, mehrere Datenerfassungsfenster, die während unterschiedlicher Intervalle, aber in dem gleichen Bereich aufgenommen wurden, zu vereinen. So kann zum Beispiel vorgesehen sein, Daten aus einem ersten Schwallbereich mit Daten aus einem zweiten Schwallbereich zu kombinieren, wodurch die Auflösung des kombinierten Bildes verbessert wird.

Weiter ist vorgesehen, dass zur Datenerfassung ein Ordnungsschema basierend auf Quasi-Randomisierung angewendet wird. Solche auf Quasi-Randomisierung oder Subrandomisierung basierenden Ordnungsschemata garantieren ebenfalls eine nahezu gleichmäßige Verteilung der Datenprofile für eine beliebige Anzahl von für die Datenaufnahme verwendeten Datenprofilen. Ordnungsschemata diesen Typs basieren auf Sequenzen mit niedriger Abweichung. Sequenzen niedriger Abweichung werden auch als Quasi-Zufalls-sequenzen bezeichnet. Im Gegensatz zu rein vorherbestimmten Sequenzen bieten die Quasi-Zufallssequenzen den Vorteil, dass sie trotz nicht vorbestimmter Datenprofilanzahl eine gleichmäßige Verteilung ermöglichen, demnach also die Anzahl der Datenprofile auch nachträglich an die herrschenden Bedingungen bei der Durchflussmessung angepasst werden kann. Insbesondere eignen sich für die Datenerfassung sehr gut die Halton-Sequenz, die van der Corput-Sequenz und die Faure-Sequenz.

## Patentansprüche

1. Verfahren zum Betreiben eines kernmagnetischen Durchflussmessgerätes zur Bestimmung des Durchflusses eines durch ein Messrohr mit Schwallströmung strömenden Mediums mit einer Messeinrichtung,
wobei die Messeinrichtung einen RF-Kreis mit einer externen Elektronik und mit mindestens einer zum Erzeugen von das Medium anregenden Anregungssignalen und/oder zur Detektion von vom Medium ausgesandten Messsignalen ausgestalteten RF-Spule umfasst,
wobei ein Schwallbereich der Schwallströmung durch einen Schwall an flüssigem Medium gekennzeichnet ist und das flüssige Medium den gesamten Messrohrquerschnitt ausfüllt und ein Filmbereich der Schwallströmung aus einer einen dominierenden Teil des Messrohrquerschnitts einnehmenden großen Gasblase und einem den verbleibenden Messrohrquerschnitt ausfüllenden Flüssigkeitsfilm besteht, wobei "tuning"-Parameter und "matching"-Parameter bestimmt werden, wobei durch "tuning" die Frequenz des RF-Kreises so einstellbar ist, dass Resonanz erreicht wird, und durch "matching" die Impedanz der RF-Spule der externen Elektronik anpassbar ist,
**dadurch gekennzeichnet,**
**dass** die "tuning"-Parameter und die "matching"-Parameter für einen Schwallbereich und für einen Filmbereich bestimmt werden,
**dass** die "tuning"-Parameter und die "matching"-Parameter für einen Schwallbereich eingestellt werden oder dass die "tuning"-Parameter und die "matching"-Parameter für einen Filmbereich eingestellt werden, dass über eine Zeit t die reflektierte Leistung gemessen wird, wobei die reflektierte Leistung bei einem für Schwallbereich eingestellten System niedrig ist für den Schwallbereich und hoch ist für den Filmbereich und wobei die Leistung bei einem für Filmbereich eingestellten System niedrig ist für den Filmbereich und hoch ist für den Schwallbereich,
**dass** anhand der reflektierten Leistung die relativen Verweilzeiten der Schwallbereiche und Filmbereiche in der RF-Spule sowie die relativen Häufigkeiten der Schwallbereiche und Filmbereiche im strömenden Medium bestimmt werden und
**dass** der Sprung in dem Wert der reflektierten Leistung von einem hohen Wert zu einem niedrigen Wert als Auslöser zum Starten einer Messung genutzt wird.

2. Verfahren nach Anspruch 1, **dadurch gekennzeichnet, dass** die Messung eine Messung zur Optimierung der "tuning"-Parameter und der "matching"-Parameter ist, dass startend von den Anfangsparametern weitere Punkte im "tuning"-Parameterraum und im "matching"-Parameterraum vermessen werden, wobei die Anzahl der Messpunkte auf der bekannten minimalen Schwallverweilzeit und der Zeit, die ein einzelner "tuning"-Messpunkt und einzelner "matching"-Messpunkt benötigt, basiert, dass nach der Aufnahme der Messpunkte die Anfangsparameter wieder eingestellt werden und überprüft wird, ob die reflektierte Leistung noch einen niedrigen Wert hat und dass ein Teil der aufgenommenen Messpunkte verworfen wird oder alle aufgenommenen Messpunkte verworfen werden, wenn die reflektierte Leistung bei der Überprüfung einen hohen Wert hat.

3. Verfahren nach Anspruch 1, **dadurch gekennzeichnet, dass** die Messung eine kernmagnetische Messung ist.

4. Verfahren nach Anspruch 3, **dadurch gekennzeichnet, dass** die Daten der reflektierten Leistung genutzt werden, um einzelne Daten aus der kernmagnetischen Messung zu akzeptieren oder zu verwerfen, wobei insbesondere die Daten der kernmagnetischen Messung verworfen werden können, die zum Zeitpunkt eines Sprungs in der reflektierten Leistung aufgenommen wurden oder die Daten der kernmagnetischen Messung verworfen werden können, die mit "falschen" "tuning"-Parametern und/oder falschen "matching"-Parametern aufgenommen wurden.

5. Verfahren nach Anspruch 3 oder 4, **dadurch gekennzeichnet, dass** die "tuning"-Parameter und die "matching"-Parameter für einen Schwallbereich eingestellt werden, dass die kernmagnetische Messung mit einer CPMG-Sequenz oder einer anderen Pulssequenz zur Bestimmung kernmagnetischer Größen realisiert wird, wobei die Methode der Vormagnetisierungskontrastmessung genutzt wird und dass mit den Messdaten die Strömungsgeschwindigkeit und mit den Signalamplituden das Wasser-Flüssigkeits-Verhältnis bestimmt werden.

6. Verfahren nach Anspruch 3 oder 4, **dadurch gekennzeichnet, dass** die "tuning"-Parameter und die "matching"-Parameter für einen Schwallbereich eingestellt werden, dass die kernmagnetische Messung Tomographie mit Schichtung in z-Richtung senkrecht zur Strömungsrichtung realisiert, dass mit den gemessenen Signalamplituden der Gasanteil (Gas-Volumen-Fraktion) in den Schwallbereichen bestimmt wird und dass die Strömungsgeschwindigkeitsverteilung in dem Schwallbereich bestimmt wird.

7. Verfahren nach Anspruch 5, **dadurch gekennzeichnet, dass** eine kernmagnetische Messung mit "tuning"-Parametern und "matching"-Parametern für einen Schwallbereich in einem Filmbereich durchgeführt wird, dass mit den Messwerten die Strömungsgeschwindigkeit bestimmt wird und dass mit den bestimmten Werten der Strömungsgeschwindigkeit und den vorher bestimmten Werten für das Wasser-zu-Flüssigkeits-Verhältnis die Durchflussraten ermittelt werden.

8. Verfahren nach Anspruch 3 oder 4, **dadurch gekennzeichnet, dass** die "tuning"-Parameter und "matching"-Parameter für einen Filmbereich eingestellt werden, dass die kernmagnetische Messung mit einer CPMG-Sequenz oder einer anderen Pulssequenz zur Bestimmung kernmagnetischer Größen realisiert wird, wobei die Methode der Vormagnetisierungskontrastmessung genutzt wird und dass mit den Messdaten die Strömungsgeschwindigkeit und mit den Signalamplituden das Wasser-zu-Flüssigkeits-Verhältnis bestimmt werden.

9. Verfahren nach Anspruch 3 oder 4, **dadurch gekennzeichnet, dass** die "tuning"-Parameter und "matching"-Parameter für einen Filmbereich eingestellt werden, dass die kernmagnetische Messung Tomographie mit Schichtung in z-Richtung senkrecht zur Strömungsrichtung realisiert, und dass mit den gemessenen Signalamplituden der Gasanteil (Gas-Volumen-Fraktion) in dem Film, sowie das Flüssigkeitslevel bestimmt werden.

10. Verfahren nach Anspruch 8, **dadurch gekennzeichnet, dass** eine kernmagnetische Messung mit "tuning"-Parametern und "matching"-Parametern für einen Filmbereich in einem Schwallbereich durchgeführt wird, dass aus den Messwerten die Strömungsgeschwindigkeit bestimmt wird und dass mit den bestimmten Werten der Strömungsgeschwindigkeit und den vorher bestimmten Werten für das Wasser-zu-Flüssigkeits-Verhältnis die Durchflussraten ermittelt werden.

11. Verfahren nach Anspruch 3, **dadurch gekennzeichnet, dass** die Messung durch kernmagnetische Tomographie mit Schichtung in z-Richtung senkrecht zur Strömungsrichtung realisiert wird und dass die Messung über einen mindestens einen Schwallbereich und einen Filmbereich umfassenden Zeitraum durchgeführt wird, dass aus den gemessenen Daten die Strömungsgeschwindigkeiten bestimmt werden und dass anhand der Daten der reflektierten Leistung die Strömungsgeschwindigkeiten einem Bereich zugeordnet werden.

## Claims

1. Method for operating a nuclear magnetic flowmeter for determining the flow of a medium with slug flow flowing through a measuring tube with a measuring device,
wherein the measuring device contains an RF circuit having external electronics and having at least one RF coil designed for generating an excitation signal for exciting the medium and/or for detecting measuring signals emitted by the medium,
wherein a slug zone of the slug flow is **characterized by** a slug of liquid medium and the liquid medium fills the entire cross section of the measuring tube, and a film zone of the slug flow consists of a large gas bubble that occupies a dominating portion of the measuring tube cross section and a liquid film that fills the remaining part of the measuring tube cross section,
wherein tuning parameters and matching parameters are determined, wherein the frequency of the RF circuit can be set using "tuning" so that resonance is achieved, and the impedance of the RF coil is adjustable to that of the external electronics for "matching"
**characterized in**
**that** the tuning parameters and the matching parameters are determined for a slug zone and for a film zone,
**that** the tuning parameters and the matching parameters are set for a slug zone or that the tuning parameters and the matching parameters are set for a film zone,
**that** the reflected power is measured over a time t, wherein the reflected power in a system set for slug zone is low for the slug zone and high for the film zone and wherein the power in a system set for film zone is low for the film zone and high for the slug zone,
**that** the relative dwell time of the slug zone and the film zone in the RF coil as well as the relative frequency of the slug zones and film zones in the flowing medium are determined using the reflected power and
**that** the jump in the value of the reflected power from a high value to a lower value is used as a trigger for starting measurement.

2. Method according to claim 1, **characterized in that** the measurement is a measurement for optimizing the tuning parameters and the matching parameters, that, beginning from the start parameters, further points in the tuning parameter range and in the matching parameter range are measured, wherein the number of measurement points is based on the known minimum slug dwell time and the time required for a single tuning measurement point and a single matching measurement point, that after recording the measurement points, the start parameter is set again and it is tested whether the reflected power still has a low value and that a part of the recorded measurement points is discarded or all of the recorded measurement points are discarded, if the reflected power has a high value.

3. Method according to claim 1, **characterized in that** the measurement is a nuclear magnetic measurement.

4. Method according to claim 3, **characterized in that** the data of the reflected power is used to accept or discard individual data from the nuclear magnetic measurement, wherein, in particular, the data of the nuclear magnetic measurement can be discarded that was recorded at the time of the jump in the reflected power or the data of the nuclear magnetic measurement can be discarded that was recorded with "incorrect" tuning parameters and/or "incorrect" matching parameters.

5. Method according to claim 3 or 4, **characterized in that** the tuning parameters and the matching parameters are set for a slug zone, that the nuclear magnetic measurement is implemented with a CPMG sequence or another pulse sequence for determining nuclear magnetic variables, wherein the method of pre-magnetization contrast measurement is used and that the flow velocity is determined with the measurement data and the water to liquid ratio is determined with the signal amplitudes.

6. Method according to claim 3 or 4, **characterized in that** the tuning parameters and the matching parameters are set for a slug zone, that the nuclear magnetic measurement implements tomography with slicing in the z-direction orthogonal to the direction of flow, that the gas portion (gas volume fraction) in the slug zones is determined with the measured signal amplitudes and that the flow velocity distribution is determined in the slug zone.

7. Method according to claim 5, **characterized in that** a nuclear magnetic measurement with tuning parameters and matching parameters for a slug zone is carried out in a film zone, that the flow velocity is determined with the measured values and that the flow rate is calculated with the determined values for the flow velocity and the previously determined values for the water to liquid ratio.

8. Method according to claim 3 or 4, **characterized in that** the tuning parameters and the matching parameters are set for a film zone, that the nuclear magnetic measurement is implemented with a CPMG sequence or another pulse sequence for determining nuclear magnetic variables, wherein the method of pre-magnetization contrast measurement is used and that the flow velocity is determined with the measurement data and the water to liquid ratio is determined with the signal amplitudes.

9. Method according to claim 3 or 4, **characterized in that** the tuning parameter and matching parameter are set for a film zone, that the nuclear magnetic measurement implements tomography with slicings in the z-direction orthogonal to the direction of flow and that the gas portion (gas volume fraction) in the film as well as the liquid level are determined with the measured signal amplitudes.

10. Method according to claim 8, **characterized in that** a nuclear magnetic measurement with tuning parameters and matching parameters for a film zone is carried out in a slug zone, that the flow velocity is determined with the measured values and that the flow rate is calculated with the determined values for the flow velocity and the previously determined values for the water to liquid ratio.

11. Method according to claim 3, **characterized in that** measurement is implemented using nuclear magnetic tomography with layers in the z-direction orthogonal to the direction of flow and that the measurement is carried out over a time period encompassing at least one slug zone and one film zone, that the flow velocities are determined from the measured data and that the flow velocities are assigned to a zone using the data of the reflected power.

## Revendications

1. Procédé, destiné à faire fonctionner un débitmètre magnétique nucléaire pour déterminer le débit d'un milieu circulant avec un écoulement à bouchons à travers un tube de mesure, doté d'un système de mesure,
le système de mesure comprenant un circuit RF doté d'une électronique externe et d'au moins une bobine RF conçue pour générer des signaux d'excitation pour exciter le milieu et/ou pour détecter des signaux de mesure émis par le milieu, une zone de bouchon de l'écoulement à bouchons étant **caractérisée par** un bouchon de milieu liquide et le milieu liquide remplissant l'ensemble de la section transversale du tube de mesure et une zone filmogène de l'écoulement à bouchons étant constituée d'une grande bulle de gaz occupant une partie dominante de la section transversale du tube de mesure et d'un film de liquide remplissant la section transversale restante du tube de mesure, des paramètres de « tuning » et des paramètres de « matching » étant déterminés, sachant que par « tuning », la fréquence du circuit RF est réglable de sorte à atteindre une résonance et par « matching », l'impédance de la bobine RF de l'électronique externe est adaptable, **caractérisé**
**en ce qu'**on détermine les paramètres de « tuning » et les paramètres de « matching » pour une zone de bouchon et pour une zone filmogène,
**en ce qu'**on règle les paramètres de « tuning » et les paramètres de « matching » pour une zone de bouchon ou en ce qu'on règle les paramètres de « tuning » et les paramètres de « matching » pour une zone filmogène,
**en ce que** sur une durée t, on mesure la puissance réfléchie, sachant que la puissance réfléchie est faible pour la zone de bouchon et élevée pour la zone filmogène sur un système réglé pour une zone à bouchon et la puissance réfléchie est faible pour la zone filmogène et élevée pour la zone de bouchon sur un système réglé pour la zone filmogène,
**en ce qu'**à l'aide de la puissance réfléchie, on détermine les temps relatifs de séjour des zones à bouchons et des zones filmogènes dans la bobine RF, ainsi que les fréquences de survenance relatives des zones de bouchons et des zones filmogènes dans le milieu circulant et
et **en ce qu'**on utilise le saut de la valeur de la puissance réfléchie d'une valeur élevée vers une faible valeur comme déclencheur du démarrage d'une mesure.

2. Procédé selon la revendication 1, **caractérisé en ce que** la mesure est une mesure destinée à optimiser les paramètres de « tuning » et les paramètres de « matching », **en ce qu'**en partant des paramètres de départ, on mesure d'autres points dans l'espace des paramètres de « tuning » et dans l'espace des paramètres de « matching », sachant que le nombre des points de mesure est basé sur le temps minimal connu de séjour du bouchon et sur le temps nécessaire pour un point de mesure individuel de « tuning » et un point de mesure individuel de « matching », **en ce qu'**après la relève des points de mesure, on règle de nouveau les paramètres de départ et on vérifie si la puissance réfléchie adopte encore une faible valeur et **en ce qu'**on rejette une partie des points de mesure relevés ou tous les points de mesure relevés si lors de la vérification, la puissance réfléchie adopte toujours une valeur élevée.

3. Procédé selon la revendication 1, **caractérisé en ce que** la mesure est une mesure magnétique nucléaire.

4. Procédé selon la revendication 3, **caractérisé en ce qu'**on utilise les données de la puissance réfléchie pour accepter ou pour rejeter des données individuelles de la mesure magnétique nucléaire, sachant que notamment peuvent être rejetées les données de la mesure magnétique nucléaire qui ont été enregistrées au moment d'un saut de la puissance réfléchie ou peuvent être rejetées les données de la mesure magnétique nucléaire qui ont été enregistrées avec de « faux » paramètres de « tuning » et/ou de faux paramètres de « matching ».

5. Procédé selon la revendication 3 ou 4, **caractérisé en ce qu'**on règle les paramètres de « tuning » et les paramètres de « matching » pour une zone de bouchon, **en ce qu'**on procède à la mesure magnétique nucléaire avec une séquence CPMG ou une autre séquence d'impulsions pour déterminer des grandeurs magnétiques nucléaires, sachant qu'on recourt à la méthode de mesure de contraste par prémagnétisation et **en ce qu'**avec les données de mesure, on détermine la vitesse de circulation et avec les amplitudes des signaux, on détermine le rapport eau à liquide.

6. Procédé selon la revendication 3 ou 4, **caractérisé en ce qu'**on règle les paramètres de « tuning » et les paramètres de « matching » pour une zone de bouchon, **en ce qu'**on procède à la mesure magnétique nucléaire par tomographie par tranches dans la direction z, à la perpendiculaire de la direction de circulation, **en ce qu'**avec les amplitudes de signaux mesurées, on détermine la part gazeuse (fraction volumique de gaz) dans les zones de bouchon et **en ce qu'**on détermine la distribution de la vitesse de circulation dans la zone de bouchon.

7. Procédé selon la revendication 5, **caractérisé en ce qu'**on procède à une mesure magnétique nucléaire avec des paramètres de « tuning » et des paramètres de « matching » pour une zone de bouchon dans une zone filmogène, **en ce qu'**à partir des valeurs mesurées, on détermine la vitesse de circulation et **en ce qu'**avec les valeurs déterminées pour la vitesse de circulation et les valeurs précédemment déterminées pour le rapport eau à liquide, on détermine les taux de débit.

8. Procédé selon la revendication 3 ou 4, **caractérisé en ce que** qu'on règle les paramètres de « tuning » et les paramètres de « matching » pour une zone filmogène, **en ce qu'**on procède à la mesure magnétique nucléaire avec une séquence CPMG ou une autre séquence d'impulsions pour déterminer des grandeurs magnétiques nucléaires, sachant qu'on recourt à la méthode de mesure de contraste par prémagnétisation et **en ce qu'**avec les données de mesure, on détermine la vitesse de circulation et avec les amplitudes des signaux, on détermine le rapport eau à liquide.

9. Procédé selon la revendication 3 ou 4, **caractérisé en ce qu'**on règle les paramètres de « tuning » et les paramètres de « matching » pour une zone filmogène, **en ce qu'**on procède à la mesure magnétique nucléaire par tomographie par tranches dans la direction z, à la perpendiculaire de la direction de circulation, **en ce qu'**avec les amplitudes de signaux mesurées, on détermine la part gazeuse (fraction volumique de gaz) dans le film, ainsi que le niveau de liquide.

10. Procédé selon la revendication 8, **caractérisé en ce qu'**on procède à une mesure magnétique nucléaire avec des paramètres de « tuning » et des paramètres de « matching » pour une zone filmogène dans une zone de bouchon, **en ce qu'**à partir des valeurs mesurées, on détermine la vitesse de circulation et **en ce qu'**avec les valeurs déterminées pour la vitesse de circulation et les valeurs précédemment déterminées pour le rapport eau à liquide, on détermine les taux de débit.

11. Procédé selon la revendication 3, **caractérisé en ce qu'**on procède à la mesure magnétique nucléaire par tomographie par tranches dans la direction z, à la perpendiculaire de la direction de circulation et **en ce qu'**on procède à la mesure sur une période comprenant au moins une zone de bouchon et une zone filmogène, **en ce qu'**à partir des données mesurées, on détermine les vitesses de circulation et **en ce qu'**à l'aide des données de la puissance réfléchie, on affecte les vitesses de circulation à une zone.
